# EUROPEAN PATENT APPLICATION

(11) **EP 4 804 783 A1**
(43) Date of publication of application: **09.09.2026**
(21) Application number: 26161483.8
(22) Date of filing: 27.02.2026
(51) Int. Cl.: H10W 42/20, H10W 90/10, H10W 90/20, H10W 90/22, H10W 90/00

(54) **RADIO-FREQUENCY/ELECTROMAGNETIC SHIELDING FOR SYSTEM-IN-PACKAGE**

(30) Priority: 06.03.2025 US 202519072868
(71) Applicant: Meta Platforms Technologies, LLC, Menlo Park, CA 94025 (US)
(72) Inventor: MORTAZAVI, Seyed Yahya, Menlo Park, 94025 (US); RAIZADA, Kinshuk, Menlo Park, 94025 (US); CHEE, Yuen Hui, Menlo Park, 94025 (US)
(74) Representative: Murgitroyd & Company

(57) **Abstract**

A device of the subject technology includes a radiofrequency (RF) circuit enclosed within a shielding and an RF cage partially enclosing components of the RF circuit. The RF cage is configured to protect RF components of the RF circuit against an electromagnetic interference (EMI) caused by the components. The RF cage is partially embedded within a printed circuit board (PCB), and the RF circuit is mounted on the PCB via a number of ball grid arrays (BGAs).

## Description

### TECHNICAL FIELD

The present disclosure generally relates to electromagnetic (EM) shielding, and more particularly to methods in radiofrequency (RF)/EM shielding for system-in-package (SIP) applications.

### BACKGROUND

A shielding can be on a printed-circuit board (PCB) and is a metal enclosure designed to protect sensitive electronic components from EM interference (EMI) and RF interference (RFI). A two-compartment shielding is particularly useful in complex circuits where different sections of the PCB need to be isolated from each other to prevent crosstalk and interference. Each compartment acts as a Faraday cage, blocking external electromagnetic fields and containing any emissions from the components within. This is crucial in high-frequency applications, such as RF communication devices, where even minor interference can significantly impact performance. The compartments are typically made from materials such as tin-plated steel or aluminum, which offer excellent shielding properties while being easy to manufacture and integrate into the PCB design.

The design of a two-compartment shielding can also allow for better thermal management. By isolating heat-generating components, it helps in dissipating heat more efficiently, thereby enhancing the overall reliability and lifespan of the PCB. Additionally, the compartments can be designed with removable lids, making it easier to access and service the components without compromising the shielding effectiveness. This modular approach is highly beneficial in prototyping and testing phases, where frequent adjustments and measurements are required. Overall, the two-compartment shielding is a versatile solution that addresses both EMI/RFI shielding and thermal management, making it an essential component in modern electronic design. However, because of the relatively large area and volume of the existing shielding cans, the existing solutions are not available for application where there are space limitations, for example, in mixed reality (MR) devices such as augmented reality (AR) and/or smart glasses.

### SUMMARY

According to some embodiments, a device of the subject technology includes an RF circuit enclosed within a shielding and an RF cage partially enclosing components of the RF circuit. The RF cage is configured to protect RF components of the RF circuit against an EMI caused by the components. The RF cage is partially embedded within a PCB, and the RF circuit is mounted on the PCB via several ball grid arrays (BGAs).

In some embodiments, the RF circuit comprises an RF system-in-package (SIP).

In some embodiments, the shielding comprises a conformal EMI shielding partially enclosing the RF circuit.

In some embodiments, the plurality of components comprise power-supply circuit components and oscillator circuit components.

In some embodiments, the RF components comprise parts of the RF circuit that are vulnerable to an EMI generated by the plurality of components.

In some embodiments, the RF cage is formed by ground metal routings within the RF circuit and the PCB and via fencings and structurally includes all ground inner BGAs.

In some embodiments, the RF cage comprises a Faraday cage and is made of a conductive metal including copper, aluminum, stainless steel and nickel.

According to some embodiments, a device of the subject technology includes an RF circuit enclosed within a shielding and an RF cage configured to protect one or more RF components of the RF circuit against EMI caused by at least one component of the RF circuit. The RF cage is configured to enclose the at least one component of the RF circuit. The RF circuit is configured to be mounted on a PCB using a plurality of BGAs, and the shielding, the RF circuit and the RF cage are configured to be independent from the PCB.

In some embodiments, the at least one component of the RF circuit comprises power supply components and oscillator circuit components.

In some embodiments, the one or more RF components comprise components of the RF circuit that are sensitive to the EMI generated by the at least one component.

In some embodiments, the shielding comprises a conformal EMI shielding configured to partially enclose the RF circuit.

In some embodiments, the RF cage is formed by ground metal routings within the RF circuit and via fencings in a substrate of the RF circuit.

In some embodiments, the RF circuit comprises an RF SIP.

In some embodiments, the via fencings comprise a first thickness.

In some embodiments, the via fencings comprise a second thickness greater than the first thickness.

In some embodiments, routings from a bottom side to a top side of the RF cage are shielded to reduce undesired coupling.

According to some embodiments, a method of the subject technology includes enclosing an RF SIP within a conformal shielding and protecting RF components of the RF SIP against an EMI caused by a plurality of components of the RF SIP using an RF cage. Using the RF cage comprises enclosing the components of the RF SIP by the RF cage to protect the RF components against EMI generated by the components. The RF SIP is mounted on a PCB using a plurality of BGAs.

In some embodiments, the method further comprises forming the RF cage by embedding a portion of the RF cage within the PCB, wherein the embedded portion includes a ground routing and two or more BGAs.

In some embodiments, the method further comprises forming the RF cage by ground metal routings within the RF SIP and via fencings in a substrate of the RF SIP, wherein the RF cage is entirely embedded within the RF SIP.

In some embodiments, the via fencings comprise one of a first thickness or a second thickness, wherein the second thickness is greater than the first thickness.

### BRIEF DESCRIPTION OF THE DRAWINGS

The accompanying drawings, which are included to provide further understanding and are incorporated in and constitute a part of this specification, illustrate disclosed embodiments and together with the description serve to explain the principles of the disclosed embodiments.
FIG. 1 is a high-level diagram illustrating a smart glass within which some aspects of the subject technology is implemented.
FIG. 2A is a schematic diagram illustrating an example of an SIP module including an RF SIP and an RF cage to provide RF/EM shielding, in accordance with some aspects of the subject technology.
FIG. 2B is a schematic diagram illustrating an example SIP module including an RF SIP without an RF cage demonstrating the interference from the aggressor circuits reaching the RF components.
FIG. 3 is a schematic diagram illustrating an example of an SIP module including an RF SIP and an RF cage to provide RF/EM shielding, in accordance with some aspects of the subject technology.
FIG. 4 is a schematic diagram illustrating an example of an SIP module including an RF SIP and an RF cage to provide RF/EM shielding, in accordance with some aspects of the subject technology.
FIG. 5 is a flow diagram illustrating an example of a method of shielding an RF SIP using an RF cage, according to some embodiments.

In one or more implementations, not all of the depicted components in each figure may be required, and one or more implementations may include additional components not shown in a figure. Variations in the arrangement and type of the components may be made without departing from the scope of the subject disclosure. Additional components, different components, or fewer components may be utilized within the scope of the subject disclosure.

### DETAILED DESCRIPTION

The detailed description set forth below describes various configurations of the subject technology and is not intended to represent the only configurations in which the subject technology may be practiced. The detailed description includes specific details for the purpose of providing a thorough understanding of the subject technology. Accordingly, dimensions may be provided in regard to certain aspects as non-limiting examples. However, it will be apparent to those skilled in the art that the subject technology may be practiced without these specific details. In some instances, well-known structures and components are shown in block diagram form in order to avoid obscuring the concepts of the subject technology.

It is to be understood that the present disclosure includes examples of the subject technology and does not limit the scope of the included clauses. Various aspects of the subject technology will now be disclosed according to particular but non-limiting examples. Various embodiments described in the present disclosure may be carried out in different ways and variations, and in accordance with a desired application or implementation.

In the following detailed description, numerous specific details are set forth to provide a full understanding of the present disclosure. It will be apparent, however, to one ordinarily skilled in the art, that embodiments of the present disclosure may be practiced without some of the specific details. In other instances, well-known structures and techniques have not been shown in detail so as not to obscure the disclosure.

In some aspects, the subject technology is directed to methods in RF/EM shielding for SIP applications. The disclosed technology includes providing an RF cage surrounding one or more aggressor circuitry (e.g., a buck converter, a boost converter, a crystal oscillator and the like) to prevent interference from the aggressor circuity to one or more RF components. The RF components can be parts of an RF SIP module sharing a PCB with the aggressor circuity.

In some implementations, the RF cage includes a first portion surrounding the aggressor circuitry and a second portion that embeds a slice of the PCB. The first portion and the second portion are coupled via solder balls of a ground inner ball-grid array (BGA). This RF cage is made by ground metal routing and via fencing both in SIP and PCB to trap the undesired signals. The routings from bottom side to top side are shielded carefully to minimize undesired coupling.

In some implementations, the RF cage includes a metal coating and surrounds the aggressor circuitry. The RF cage of this implementation does not embed any part of the PCB. The integrated shielding forms a can on the bottom side of the RF SIP as part of the RF cage and is made by ground metal routing and via fencing in the RF SIP to trap the undesired signals. The routings from bottom side to top side are shielded carefully to minimize undesired coupling.

In some implementations, the RF cage consists of a metal integrated RF cage that surrounds the aggressor circuitry and is formed on the bottom side of the RF SIP. The metal integrated RF cage is formed by ground metal routing and via fencing in the SIP substrate to trap the undesired signals. The routings from bottom side to top side are shielded carefully to minimize undesired coupling.

The RF SIP is a path to enabling artificial intelligence (AI) in MR and/or smart glasses for socially acceptable glasses by reducing the weight and size of these devices. The RF SIP also enables more features in consumer electronics and allows on-device computing to enable AI features at low latency. In the current technology, components are unshielded on the bottom of the RF SIP, which can result in causing regulatory failure limits when a power supply is integrated with other subsystems (e.g., wireless components). The disclosed solution enables integration of power supply with other subsystems in small form factors to achieve new features such as AI and on-device computation capability. Additionally, the use of the subject technology can be extended to other applications including, but not limited to, neural-processing units (NPUs), central-processing units (CPUs), cameras and sensors.

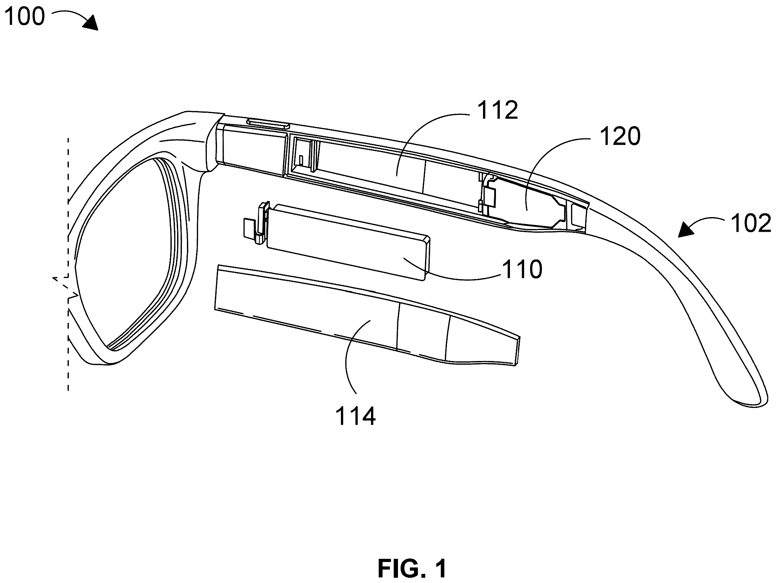

Turning now to the figures, FIG. 1 is a high-level diagram illustrating a smart glass 100 within which some aspects of the subject technology are implemented. In FIG. 1, only a portion of the smart glass 100 including a temple arm 102 is shown. The temple arm 102 includes an RF SIP module 110, which can be suitably placed in a cavity 112 and covered by a cover 114. The RF SIP module 110 can be coupled via appropriate connectors to other modules, for example, an electronic module 120 including, for instance, a power source such as a battery and corresponding electronics, and possibly, a voltage regulator.

The RF SIP module 110 may include RF circuits and other electronic circuitry that may be electromagnetically aggressor circuitry (e.g., a buck converter, a boost converter, a crystal oscillator and the like). In order to protect the RF circuits of the RF SIP module 110 from EM interference of the aggressor circuitry, the subject technology provides suitable RF/EM shielding structures that can drastically limit the EM interferences and warrant proper operations of the RF circuits, as discussed in more detail herein.

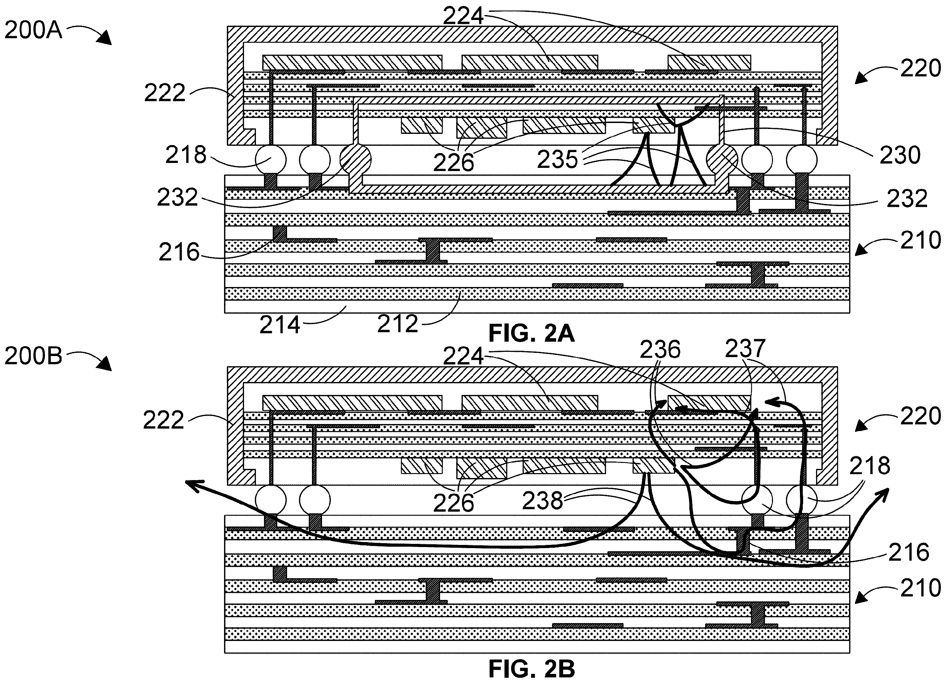

FIG. 2A is a schematic diagram illustrating an example of an SIP module 200A including an RF SIP and an RF cage to provide RF/EM shielding, in accordance with some aspects of the subject technology. The RF SIP module 200A includes a PCB 210, an RF SIP 220, partially covered by a conformal shielding 222, and an RF cage 230.

The PCB 210 is a substrate and includes multiple conductive traces 212 isolated by multiple nonconductive (e.g., insulator) traces 214. Some of the conductive traces are electrically connected to each other using conductive through vias 216. The RF SIP 220 is electrically coupled to the PCB 210 by using conductive solder balls 218 of a BGA.

The RF SIP 220 includes RF components 224 (victims) as well as aggressor circuits 226. Examples of the RF components 224 include, but are not limited to, RF preamplifiers, filters, mixers, amplifiers and the like. Examples of the aggressor circuits 226 include, but are not limited to, buck converters, boost converters, crystal oscillators and the like. The aggressor circuits 226 generate EM interferences that can disturb functions of the RF components 224. In order to reduce or eliminate these undesired signals (EM interferences), the aggressor circuits 226 are shielded by the RF cage 230 of the subject technology. As shown in FIG. 2A, the EM interferences 235 from the aggressor circuits 226 are constrained within the RF cage 230 and restricted from reaching the RF components 224. The RF cage 230 embracing the aggressor circuits 226 include the ground BGA solder balls 232 and provide fencing both in the RF SIP 220 and the PCB 210 to trap the undesired signals. The routings from the bottom side to the top side are shielded carefully to minimize undesired coupling.

In some implementations, the conformal shielding 222 can be made of copper or other suitable metal materials and has an example thickness within a range of about 0.005 to 0.01 mm. The integrated shielding, RF cage 230, can be made of copper, aluminum or other suitable metal materials and has an example thickness within a range of about 0.1 to 0.3 mm. The RF SIP substrate includes copper laminates and has an example thickness within a range of about 0.3 to 0.4 mm. The PCB 210 includes a flame retardant 4 (FR4) or similar material and has an example thickness within a range of about 0.5 to 1 mm.

FIG. 2B is a schematic diagram illustrating an example SIP module 200B including an RF SIP without an RF cage demonstrating the interference from the aggressor circuits reaching the RF components. The SIP module 200B is similar to the SIP module 200A except that the SIP module 200B is missing the RF cage 230 of FIG. 2A that could restrict the EM interferences from reaching the RF components 224 of the RF SIP 220. Without the RF cage 230 of FIG. 2A, as shown in FIG. 2B, the undesired signals (EM interferences) 236 and 237 can reach the RF components 224. The undesired signals 236 can pass through the RF SIP 220, and the undesired signals 237 can find their way through the vias 216 and conductive solder balls 218 to reach the RF components 224. A portion of the radiated EM interference, undesired signals 238, may escape from the SIP module 200B.

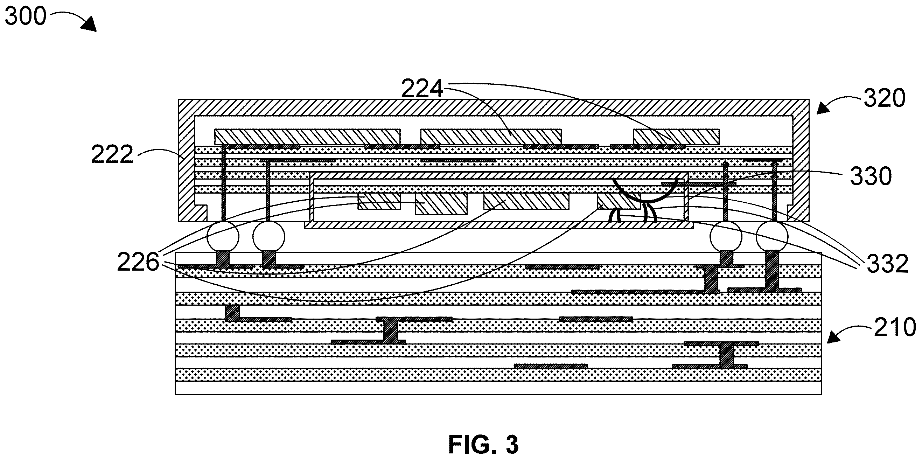

FIG. 3 is a schematic diagram illustrating an example of an SIP module 300 including an RF SIP and an RF cage to provide RF/EM shielding, in accordance with some aspects of the subject technology. The SIP module 300 is similar to the RF SIP module 200A of FIG. 2A, except that the structure of an RF cage 330 is different from the RF cage 230 of FIG. 2A. The RF cage 330 does not include portions of the PCB 210 and is contained within the conformal shielding 222. The RF cage 330 includes metal coating and has a thicker top side, which overlaps a conductive trace of the RF SIP 320. The RF cage 330 while having a simpler structure can shield the undesired signals 332 generated by the aggressor circuits 226 from reaching the RF components 224. The routings from the bottom side to the top side are shielded carefully to minimize undesired coupling.

An advantage of the SIP module 300 as compared to the SIP module 200A of FIG. 2A is that the RF SIP 320, including the RF cage 330 in the SIP module 300, is considered a standalone design that can be fabricated independently of the PCB 210 and can be integrated with the PCB 210 afterwards.

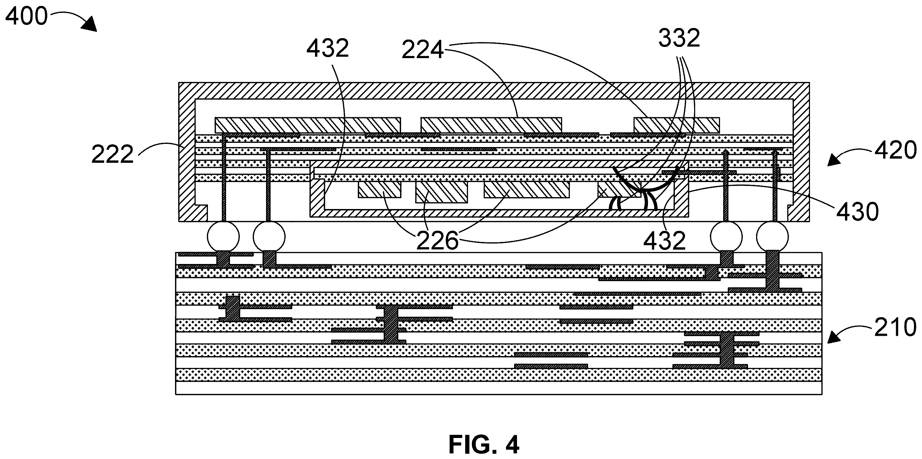

FIG. 4 is a schematic diagram illustrating an example of an SIP module 400 including an RF SIP and an RF cage to provide RF/EM shielding, in accordance with some aspects of the subject technology. The SIP module 400 is similar to the SIP module 300 of FIG. 3 except that the structure of an RF cage 430 is different from the RF cage 330 of FIG. 3. The RF cage 430 is a metal integrated RF cage on the bottom side of RF SIP 420 and includes ground metal routing, and via fencing in the substrate of the RF SIP 420 and traps the undesired signals 332 generated by the aggressor circuits 226. The routings from bottom side to top side are shielded carefully to minimize undesired coupling. In some implementations, the walls 432 of the RF cage 430 may be made thicker (e.g., by about 0.1 to 0.2 mm) than other parts of the RF cage 430, which may have thicknesses within a range of about 0.1 to 0.3 mm.

The SIP module 400 has an advantageous feature as compared to the SIP module 200A of FIG. 2A in that the RF SIP 420, including the RF cage 430 in the SIP module 400, is considered a standalone device that can be fabricated independently of the PCB 210 and can be integrated with the PCB 210 afterwards.

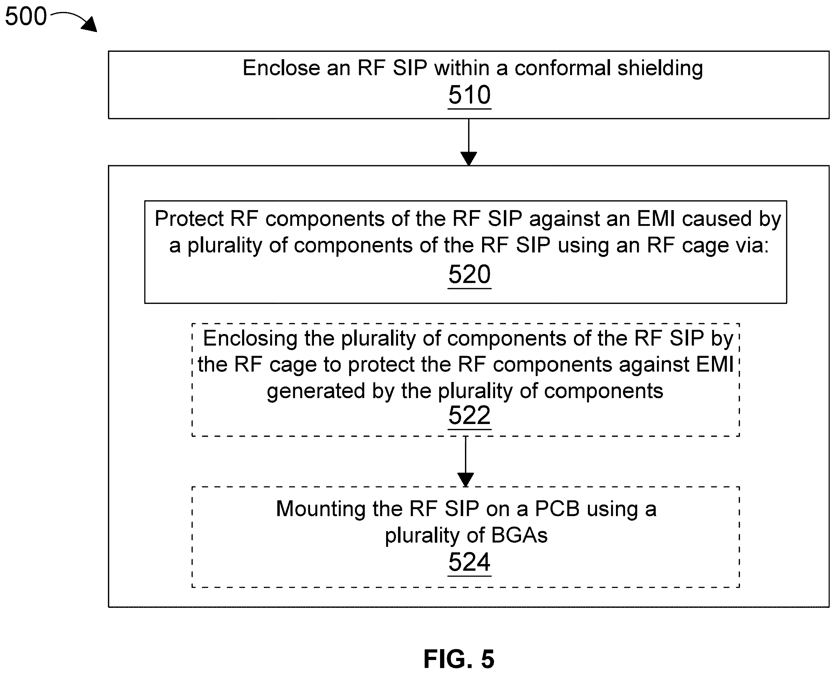

FIG. 5 is a flow diagram illustrating an example of a method 500 of shielding an RF SIP using an RF cage, according to some embodiments. The method 500 includes steps 510 and 520, which includes steps 522 and 524.

In step 510, an RF SIP is enclosed within a conformal shielding, which can reduce the EM interference from the external devices.

In step 520, RF components of the RF SIP are protected against an EMI caused by a plurality of components of the RF SIP using an RF cage by executing steps 522 and 524.

In step 522, the components of the RF SIP are enclosed by the RF cage to protect the RF components against EMI generated by the components.

In step 524, the RF SIP is mounted on a PCB using a plurality of BGAs. The BGAs provide electrical connections to the conductive traces of the PCB.

An aspect of the subject technology is directed to a device including an RF circuit enclosed within a shielding and an RF cage partially enclosing components of the RF circuit. The RF cage is configured to protect RF components of the RF circuit against an EMI caused by the components. The RF cage is partially embedded within a PCB, and the RF circuit is mounted on the PCB via several ball grid arrays (BGAs).

In some implementations, the RF circuit comprises an RF system-in-package (SIP).

In one or more implementations, the shielding comprises a conformal EMI shielding partially enclosing the RF circuit.

In some implementations, the plurality of components comprise power-supply circuit components and oscillator circuit components.

In one or more implementations, the RF components comprise parts of the RF circuit that are vulnerable to an EMI generated by the plurality of components.

In some implementations, the RF cage is formed by ground metal routings within the RF circuit and the PCB and via fencings and structurally includes all ground inner BGAs.

In one or more implementations, the RF cage comprises a Faraday cage and is made of a conductive metal including copper, aluminum, stainless steel and nickel.

Another aspect of the subject technology is directed to a device that includes an RF circuit enclosed within a shielding and an RF cage configured to protect one or more RF components of the RF circuit against EMI caused by an at least one component of the RF circuit. The RF cage is configured to enclose the at least one component of the RF circuit. The RF circuit is configured to be mounted on a PCB using a plurality of BGAs, and the shielding, the RF circuit and the RF cage are configured to be independent from the PCB.

In some implementations, the at least one component of the RF circuit comprises power supply components and oscillator circuit components.

In one or more implementations, the one or more RF components comprise components of the RF circuit that are sensitive to the EMI generated by the at least one component.

In some implementations, the shielding comprises a conformal EMI shielding configured to partially enclose the RF circuit.

In one or more implementations, the RF cage is formed by ground metal routings within the RF circuit and via fencings in a substrate of the RF circuit.

In some implementations, the RF circuit comprises an RF SIP.

In one or more implementations, the via fencings comprise a first thickness.

In some implementations, the via fencings comprise a second thickness greater than the first thickness.

In one or more implementations, routings from a bottom side to a top side of the RF cage are shielded to reduce undesired coupling.

Yet another aspect of the subject technology is directed to a method that includes enclosing an RF SIP within a conformal shielding and protecting RF components of the RF SIP against an EMI caused by a plurality of components of the RF SIP using an RF cage. Using the RF cage comprises enclosing the components of the RF SIP by the RF cage to protect the RF components against EMI generated by the components. The RF SIP is mounted on a PCB using a plurality of BGAs.

In one or more implementations, the method further comprises forming the RF cage by embedding a portion of the RF cage within the PCB, wherein the embedded portion includes a ground routing and two or more BGAs.

In some implementations, the method further comprises forming the RF cage by ground metal routings within the RF SIP and via fencings in a substrate of the RF SIP, wherein the RF cage is entirely embedded within the RF SIP.

In one or more implementations, the via fencings comprise one of a first thickness or a second thickness, wherein the second thickness is greater than the first thickness.

In some implementations, the word "exemplary" is used herein to mean "serving as an example, instance, or illustration." Any embodiment described herein as "exemplary" is not necessarily to be construed as preferred or advantageous over other embodiments. Phrases such as an aspect, the aspect, another aspect, some aspects, one or more aspects, an implementation, the implementation, another implementation, some implementations, one or more implementations, an embodiment, the embodiment, another embodiment, some embodiments, one or more embodiments, a configuration, the configuration, another configuration, some configurations, one or more configurations, the subject technology, the disclosure, the present disclosure, other variations thereof and alike are for convenience and do not imply that a disclosure relating to such phrase(s) is essential to the subject technology or that such disclosure applies to all configurations of the subject technology. A disclosure relating to such phrase(s) may apply to all configurations, or one or more configurations. A disclosure relating to such phrase(s) may provide one or more examples. A phrase such as an aspect or some aspects may refer to one or more aspects and vice versa, and this applies similarly to other foregoing phrases.

A reference to an element in the singular is not intended to mean "one and only one" unless specifically stated, but rather "one or more." Pronouns in the masculine (e.g., his) include the feminine and neuter gender (e.g., her and its) and vice versa. The term "some" refers to one or more. Underlined and/or italicized headings and subheadings are used for convenience only, do not limit the subject technology, and are not referred to in connection with the interpretation of the description of the subject technology. Relational terms such as first and second and the like may be used to distinguish one entity or action from another without necessarily requiring or implying any actual such relationship or order between such entities or actions. All structural and functional equivalents to the elements of the various configurations described throughout this disclosure that are known or later come to be known to those of ordinary skill in the art are expressly incorporated herein by reference and intended to be encompassed by the subject technology. Moreover, nothing disclosed herein is intended to be dedicated to the public, regardless of whether such disclosure is explicitly recited in the above description.

While this specification contains many specifics, these should not be construed as limitations on the scope of what may be described, but rather as descriptions of particular implementations of the subject matter. Certain features that are described in this specification in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially described as such, one or more features from a described combination can in some cases be excised from the combination, and the described combination may be directed to a sub-combination or variation of a sub-combination.

The subject matter of this specification has been described in terms of particular aspects, but other aspects can be implemented and are within the scope of the following clauses. For example, while operations are depicted in the drawings in a particular order, this should not be understood as requiring that such operations be performed in the particular order shown or in sequential order, or that all illustrated operations be performed, to achieve desirable results. The actions recited in the clauses can be performed in a different order and still achieve desirable results. As one example, the processes depicted in the accompanying figures do not necessarily require the particular order shown, or sequential order, to achieve desirable results. In certain circumstances, multitasking and parallel processing may be advantageous. Moreover, the separation of various system components in the aspects described above should not be understood as requiring such separation in all aspects, and it should be understood that the described program components and systems can generally be integrated together in a single software product or packaged into multiple software products.

The title, background, brief description of the drawings, abstract, and drawings are hereby incorporated into the disclosure and are provided as illustrative examples of the disclosure, not as restrictive descriptions. It is submitted with the understanding that they will not be used to limit the scope or meaning of the clauses. In addition, in the detailed description, it can be seen that the description provides illustrative examples, and the various features are grouped together in various implementations for the purpose of streamlining the disclosure. The method of disclosure is not to be interpreted as reflecting an intention that the described subject matter requires more features than are expressly recited in each clause. Rather, as the clauses reflect, inventive subject matter lies in less than all features of a single disclosed configuration or operation. The clauses are hereby incorporated into the detailed description, with each clause standing on its own as a separately described subject matter.

Aspects of the subject matter described in this disclosure can be implemented to realize one or more of the following potential advantages. The described techniques may be implemented to support a range of benefits and significant advantages of the disclosed eye tracking system. It should be noted that the subject technology enables fabrication of a depth-sensing apparatus that is a fully solid-state device with small size, low power, and low cost.

As used herein, the phrase "at least one of" preceding a series of items, with the terms "and" or "or" to separate any of the items, modifies the list as a whole, rather than each member of the list (i.e., each item).

To the extent that the term "include," "have," or the like is used in the description or the claims, such term is intended to be inclusive in a manner similar to the term "comprise" as "comprise" is interpreted when employed as a transitional word in a claim.

A reference to an element in the singular is not intended to mean "one and only one" unless specifically stated, but rather "one or more." All structural and functional equivalents to the elements of the various configurations described throughout this disclosure that are known or later come to be known to those of ordinary skill in the art are expressly incorporated herein by reference and intended to be encompassed by the subject technology. Moreover, nothing disclosed herein is intended to be dedicated to the public regardless of whether such disclosure is explicitly recited in the above description.

While this specification contains many specifics, these should not be construed as limitations on the scope of what may be claimed, but rather as descriptions of particular implementations of the subject matter. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

## Claims

1. A device comprising:
a radiofrequency, RF, circuit enclosed within a shielding; and
an RF cage partially enclosing a plurality of components of the RF circuit and configured to protect RF components of the RF circuit against an electromagnetic interference, EMI, caused by the plurality of components,
wherein:
the RF cage is partially embedded within a printed circuit board, PCB; and
the RF circuit is mounted on the PCB via a plurality of ball grid arrays, BGAs.

2. The device of claim 1, wherein the RF circuit comprises an RF system-in-package, SIP.

3. The device of claim 2, wherein the shielding comprises a conformal EMI shielding partially enclosing the RF circuit; and preferably
wherein the plurality of components comprises power-supply circuit components and oscillator circuit components; and/or preferably
wherein the RF components comprise parts of the RF circuit that are vulnerable to an EMI generated by the plurality of components.

4. The device of any preceding claim, wherein the RF cage is formed by ground metal routings within the RF circuit and the PCB and via fencings and structurally includes all ground inner BGAs.

5. The device of any preceding claim, wherein the RF cage comprises a Faraday cage and is made of a conductive metal including copper, aluminum, stainless steel and nickel.

6. A device comprising:
an RF circuit enclosed within a shielding; and
an RF cage configured to protect one or more RF components of the RF circuit against an EMI caused by at least one component of the RF circuit,
wherein:
the RF cage is configured to enclose the at least one component of the RF circuit;
the RF circuit is configured to be mounted on a PCB using a plurality of BGAs; and
the shielding, the RF circuit and the RF cage are configured to be independent from the PCB.

7. The device of claim 6, wherein the at least one component of the RF circuit comprises power supply components and oscillator circuit components; and preferably
wherein the one or more RF components comprise components of the RF circuit that are sensitive to the EMI generated by the at least one component; and/or preferably
wherein the shielding comprises a conformal EMI shielding configured to partially enclose the RF circuit.

8. The device of claim 6 or claim 7, wherein the RF cage is formed by ground metal routings within the RF circuit and via fencings in a substrate of the RF circuit.

9. The device of claim 8, wherein the RF circuit comprises an RF SIP.

10. The device of claim 8 or claim 9, wherein the via fencings comprise a first thickness and/or a second thickness greater than the first thickness.

11. The device of any one of claims 6 to 10, wherein routings from a bottom side to a top side of the RF cage are shielded to reduce undesired coupling.

12. A method, comprising:
enclosing an RF SIP within a conformal shielding; and
protecting RF components of the RF SIP against an EMI caused by a plurality of components of the RF SIP using an RF cage,
wherein:
using the RF cage comprises enclosing the plurality of components of the RF SIP by the RF cage to protect the RF components against the EMI generated by the plurality of components; and
the RF SIP is mounted on a PCB using a plurality of BGAs.

13. The method of claim 12, further comprising forming the RF cage by embedding a portion of the RF cage within the PCB, wherein the embedded portion includes a ground routing and two or more BGAs.

14. The method of claim 12 or claim 13, further comprising forming the RF cage by ground metal routings within the RF SIP and via fencings in a substrate of the RF SIP, wherein the RF cage is entirely embedded within the RF SIP.

15. The method of claim 14, wherein the via fencings comprise one of a first thickness and/or a second thickness greater than the first thickness.
